# EUROPEAN PATENT APPLICATION

(11) **EP 4 687 169 A1**
(43) Date of publication of application: **04.02.2026**
(21) Application number: 25192104.5
(22) Date of filing: 28.07.2025
(51) Int. Cl.: H01L 21/02, H01L 21/3105, H01L 21/32

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 29.07.2024 JP 2024122344
(71) Applicant: Kokusai Electric Corporation, Tokyo 101-0045 (JP)
(72) Inventor: NAKATANI, Kimihiko, Toyama-shi, Toyama, 9392393 (JP); MIYATA, Shoma, Toyama-shi, Toyama, 939-2393 (JP); HAMADA, Keitaro, Toyama-shi, Toyama, 9392393 (JP)
(74) Representative: Bardehle Pagenberg Partnerschaft mbB Patentanwälte Rechtsanwälte

(57) **Abstract**

There is provided a technique that includes (a) preparing a substrate (200) including a first surface, which includes a first termination and constitutes at least a portion of an inner surface of a recess, and a second surface, which includes a second termination different from the first termination, and (b) removing the first termination selectively with respect to the second termination by exposing the substrate (200) to a processing solution containing a liquid that reacts with the first termination and an additive that reduces surface tension of the liquid.

## Description

### CROSS-REFERENCE TO RELATED APPLICATION

This application is based upon and claims the benefit of priority from Japanese Patent Application No. 2024-122344, filed on July 29, 2024, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In the related art, as a process of manufacturing a semiconductor device, a substrate with a recess formed on its surface may be subjected to a predetermined process.

### SUMMARY

Some embodiments of the present disclosure provide a technique capable of selectively processing a desired surface among the inner surfaces of a recess formed in a substrate.

According to embodiments of the present disclosure, there is provided a technique that includes (a) preparing a substrate including a first surface, which includes a first termination and constitutes at least a portion of an inner surface of a recess, and a second surface, which includes a second termination different from the first termination, and (b) removing the first termination selectively with respect to the second termination by exposing the substrate to a processing solution containing a liquid that reacts with the first termination and an additive that reduces surface tension of the liquid.

### BRIEF DESCRIPTION OF DRAWINGS

The accompanying drawings, which are incorporated in and constitute a part of the specification, illustrate embodiments of the present disclosure.
FIG. 1 is a schematic diagram of a substrate processing apparatus suitably used in embodiments of the present disclosure.
FIG. 2 is a schematic diagram of a vertical process furnace of a film-forming apparatus provided in the substrate processing apparatus suitably used in the embodiments of the present disclosure, illustrating a portion of the process furnace in a vertical cross-sectional view.
FIG. 3 is a schematic diagram of the vertical process furnace of the film-forming apparatus provided in the substrate processing apparatus suitably used in the embodiments of the present disclosure, illustrating a portion of the process furnace in a cross-sectional view taken along line A-A in FIG. 2.
FIG. 4 is a schematic diagram of a cleaning apparatus provided in the substrate processing apparatus suitably used in the embodiments of the present disclosure.
FIG. 5 is a schematic diagram of a controller of the substrate processing apparatus 100 suitably used in the embodiments of the present disclosure, illustrating a control system of the controller in a block diagram.
FIG. 6A is a schematic cross-sectional view showing a surface portion of a wafer where a recess is provided on a surface of the wafer, a first base is disposed on an inner surface of the recess, and a second base is disposed on an upper surface of the recess. FIG. 6B is a schematic cross-sectional view showing a surface portion of a wafer where a recess is provided on a surface of the wafer surface, and a first base and a second base are alternately disposed on an inner surface of the recess.

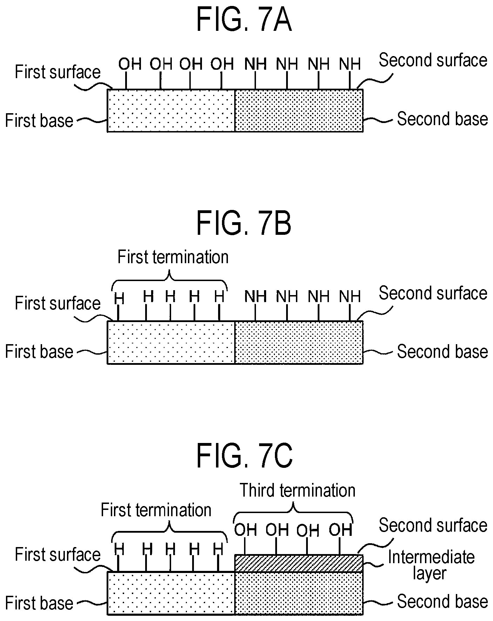

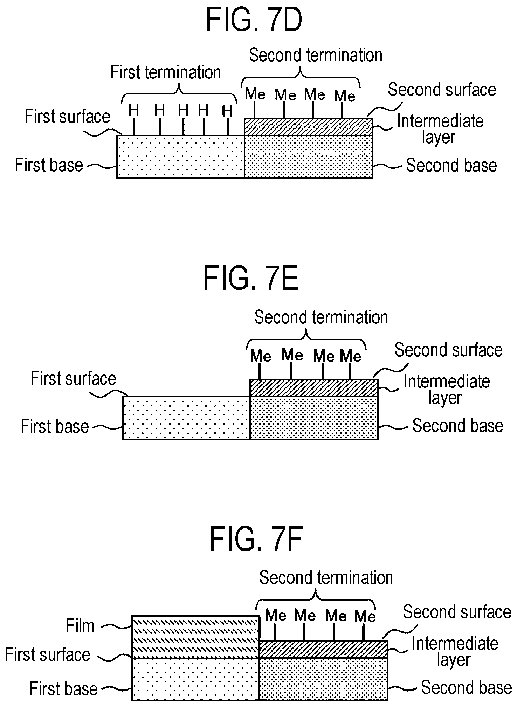

FIG. 7A is a partially enlarged cross-sectional view showing a surface portion of the wafer according to the embodiments of the present disclosure with a recess on a surface thereof. FIG. 7B is a partially enlarged cross-sectional view showing the surface portion of the wafer according to the embodiments of the present disclosure after performing step a1 from the state shown in FIG. 7A. FIG. 7C is a partially enlarged cross-sectional view showing the surface portion of the wafer according to the embodiments of the present disclosure after performing step a3 from the state shown in FIG. 7B. FIG. 7D is a partially enlarged cross-sectional view showing the surface portion of the wafer according to the embodiments of the present disclosure after performing step a2 from the state shown in FIG. 7C. FIG. 7E is a partially enlarged cross-sectional view showing the surface portion of the wafer according to the embodiments of the present disclosure after performing step B from the state shown in FIG. 7D. FIG. 7F is a partially enlarged cross-sectional view showing the surface portion of the wafer according to the embodiments of the present disclosure after performing step C from the state shown in FIG. 7E.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiments of the Present Disclosure>

Embodiments of the present disclosure are described below with reference to the drawings. The drawings used in the following description are schematic, and dimensional relationships of respective elements, proportions of respective elements, and the like shown in the drawings may not match the actual ones. Furthermore, the dimensional relationships of respective elements, the proportions of respective elements, and the like may not match among multiple drawings.

### (1) Configuration of Substrate Processing Apparatus 100

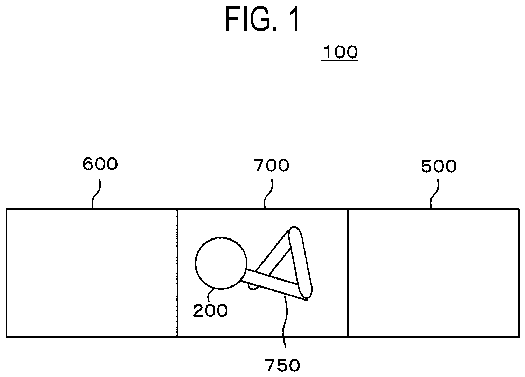

As shown in FIG. 1, the substrate processing apparatus 100 mainly includes a film-forming apparatus 500, a cleaning apparatus 600, and a transfer chamber 700.

The film-forming apparatus 500 is an apparatus that performs a film-forming process on a wafer 200 in a substrate processing process described below. The cleaning apparatus 600 is an apparatus that performs a cleaning process on the wafer 200 in the substrate processing process described below. The transfer chamber 700 is a region where the wafer 200 is transferred between the film-forming apparatus 500 and the cleaning apparatus 600.

### (i) Configuration of Film-Forming Apparatus 500

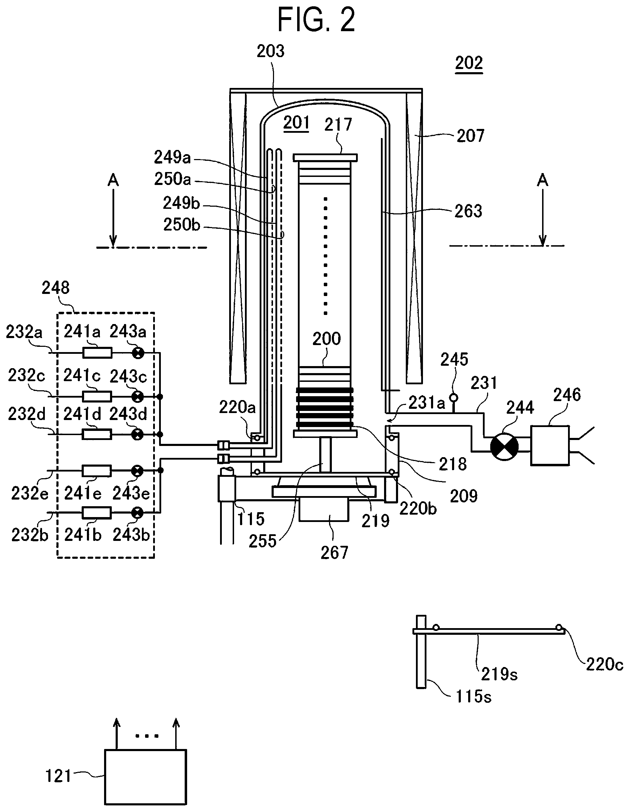

As shown in FIG. 2, a process furnace 202 includes a heater 207 as a temperature regulator (heating part). The heater 207 is formed in a cylindrical shape and is installed vertically by being supported by a holding plate. The heater 207 also functions as an activator (exciter) that activates (excites) a gas with heat.

Inside the heater 207, a reaction tube 203 is disposed concentrically with the heater 207. The reaction tube 203 is made of a heat-resistant material such as, for example, quartz (SiO₂) or silicon carbide (SiC) and is formed in a cylindrical shape with an upper end closed and a lower end opened. Below the reaction tube 203, a manifold 209 is disposed concentrically with the reaction tube 203. The manifold 209 is formed in a cylindrical shape with upper and lower ends opened. The upper end of the manifold 209 is engaged with the lower end of the reaction tube 203 and is configured to support the reaction tube 203. An O-ring 220a serving as a seal is installed between the manifold 209 and the reaction tube 203. A process container (reaction container) mainly includes the reaction tube 203 and the manifold 209. A process chamber 201 is formed in a cylindrical hollow portion of the process container. The process chamber 201 is configured to be capable of accommodating wafers 200 as substrates. The wafers 200 are processed inside the process chamber 201.

Nozzles 249a and 249b as a first supplier and a second supplier are installed in the process chamber 201 so as to penetrate a side wall of the manifold 209. The nozzles 249a and 249b are also referred to as a first nozzle and a second nozzle, respectively. The nozzles 249a and 249b are made of a heat-resistant material such as quartz or SiC. Each of the nozzles 249a and 249b is configured as a shared nozzle used to supply a plurality of types of gases.

Gas supply pipes 232a and 232b as first and second pipes are connected to the nozzles 249a and 249b, respectively. Each of the gas supply pipes 232a and 232b is configured as a shared pipe used to supply a plurality of types of gas. On the gas supply pipes 232a and 232b, mass flow controllers (MFCs) 241a and 241b as flow rate controllers (flow rate control parts) and valves 243a and 243b as opening/closing valves are respectively installed in order from an upstream of a gas flow. Each of gas supply pipes 232c and 232d is connected to the gas supply pipe 232a on a downstream of the valve 243a. On the gas supply pipes 232c and 232d, MFCs 241c and 241d and valves 243c and 243d are respectively installed in order from an upstream of the gas flow. A gas supply pipe 232e is connected to the gas supply pipe 232b on a downstream of the valve 243b. On the gas supply pipe 232e, an MFC 241e and a valve 243e are installed in order from an upstream side of a gas flow.

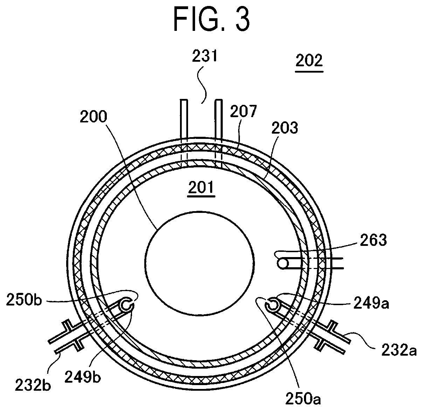

As shown in FIG. 3, the nozzles 249a and 249b are installed in a space between an inner wall of the reaction tube 203 and the wafers 200 so as to extend upward from a lower portion to an upper portion of the inner wall of the reaction tube 203 in an arrangement direction of the wafers 200. That is, the nozzles 249a and 249b are installed in a region horizontally surrounding a wafer arrangement region where the wafers 200 are arranged, on a lateral side of the wafer arrangement region, so as to extend along the wafer arrangement region. Gas supply holes 250a and 250b for supplying gases are formed on side surfaces of the nozzles 249a and 249b, respectively. The gas supply holes 250a and 250b are opened toward centers of the wafers 200 in a plane view, and are capable of supplying gases toward the wafers 200. The gas supply holes 250a and 250b are provided in multiple numbers from a lower portion to an upper portion of the reaction tube 203.

A precursor serving as a film-forming agent is supplied from the gas supply pipe 232a into the process chamber 201 via the MFC 241a, the valve 243a, and the nozzle 249a.

An oxidizing agent serving as a film-forming agent is supplied from the gas supply pipe 232b into the process chamber 201 via the MFC 241b, the valve 243b, and the nozzle 249b.

A first modifying agent and a second modifying agent are supplied from the gas supply pipe 232c into the process chamber 201 via the MFC 241c, the valve 243c, and the nozzle 249a.

An inert gas is supplied from the gas supply pipes 232d and 232e into the process chamber 201 via the MFCs 241d and 241e, the valves 243d and 243e, the gas supply pipes 232a and 232b, and the nozzles 249a and 249b. The inert gas acts as a purge gas, a carrier gas, a dilution gas, or the like.

A precursor supply system mainly includes the gas supply pipe 232a, the MFC 241a, and the valve 243a. An oxidizing agent supply system mainly includes the gas supply pipe 232b, the MFC 241b, and the valve 243b. A modifying agent (first and second modifying agents) supply system mainly includes the gas supply pipe 232c, the MFC 241c, and the valve 243c. An inert gas supply system mainly includes the gas supply pipes 232d and 232e, the MFCs 241d and 241e, and the valves 243d and 243e. The precursor supply system and the oxidizing agent supply system are also collectively referred to as a film-forming agent supply system. The nozzles connected to the gas supply pipes constituting the various supply systems described above may be included in each of the supply systems.

Any or the entirety of various supply systems described above may be configured as an integrated supply system 248 in which the valves 243a to 243e and the MFCs 241a to 241e are integrated. The integrated supply system 248 is connected to each of the gas supply pipes 232a to 232e, and is configured such that operations of supplying various substances (various gases) into the gas supply pipes 232a to 232e, i.e., opening/closing operations of the valves 243a to 243e and flow rate regulating operations by the MFCs 241a to 241e, are controlled by a controller 121 described later.

An exhaust port 231a for exhausting an atmosphere in the process chamber 201 is provided at a lower portion of a side wall of the reaction tube 203. As shown in FIG. 3, the exhaust port 231a is provided at a position facing the nozzles 249a and 249b (gas supply holes 250a to 250b) with the wafers 200 interposed therebetween in a plane view. An exhaust pipe 231 is connected to the exhaust port 231a. A vacuum pump 246 as a vacuum-exhauster is connected to the exhaust pipe 231 via a pressure sensor 245 serving as a pressure detector (pressure detection part) for detecting a pressure inside the process chamber 201 and an APC (Auto Pressure Controller) valve 244 as a pressure regulator (pressure regulation part). The APC valve 244 is configured so that it is capable of performing or stopping vacuum exhaust of an interior of the process chamber 201 by being opened or closed in a state in which the vacuum pump 246 is operated. Further, the APC valve 244 is configured so that it is capable of regulating the pressure inside the process chamber 201 by adjusting a valve opening degree based on pressure information detected by the pressure sensor 245 in a state in which the vacuum pump 246 is operated. An exhaust system mainly includes the exhaust pipe 231, the APC valve 244, and the pressure sensor 245. The vacuum pump 246 may be included in the exhaust system.

A seal cap 219 as a furnace opening lid capable of airtightly closing an opening at the lower end of the manifold 209 is installed below the manifold 209. On an upper surface of the seal cap 219, there is installed an O-ring 220b serving as a seal which abuts against the lower end of the manifold 209. Below the seal cap 219, there is installed a rotator 267 for rotating a boat 217 to be described later. A rotary shaft255 of the rotator 267 is connected to the boat 217 by penetrating through the seal cap 219. The rotator 267 is configured to rotate the wafers 200 by rotating the boat 217. The seal cap 219 is configured to be raised or lowered in a vertical direction by a boat elevator 115 as a lift installed outside the reaction tube 203. The boat elevator 115 is configured as a transfer device (transferrer) that loads or unloads (transfers) the wafers 200 into and out of the process chamber 201 by raising or lowering the seal cap 219.

Below the manifold 209, a shutter 219s is installed as a furnace opening lid capable of airtightly closing the opening at the lower end of the manifold 209 in a state in which the seal cap 219 is lowered and the boat 217 is unloaded from the process chamber 201. An O-ring 220c serving as a seal that abuts against the lower end of the manifold 209 is installed on an upper surface of the shutter 219s. Opening/closing operations (elevating operation, rotating operation, and the like) of the shutter 219s are controlled by a shutter opening/closing mechanism 115s.

A boat 217 serving as a substrate support is configured so as to support a plurality of wafers 200, for example, 25 to 200 wafers 200 in such a state that the wafers are arranged in a horizontal posture and in multiple stages along the vertical direction with centers of the wafers 200 aligned with one another, i.e., so as to arrange the wafers 200 at intervals. The boat 217 is made of a heat-resistant material such as quartz or SiC. At a lower portion of the boat 217, heat insulating plates 218 made of a heat-resistant material such as quartz or SiC are supported in multiple stages.

Inside the reaction tube 203, there is installed a temperature sensor 263 as a temperature detector. By regulating a state of supply of electric power to the heater 207 based on temperature information detected by the temperature sensor 263, a temperature inside the process chamber 201 becomes a desired temperature distribution. The temperature sensor 263 is installed along the inner wall of the reaction tube 203.

### (ii) Configuration of Cleaning Apparatus 600

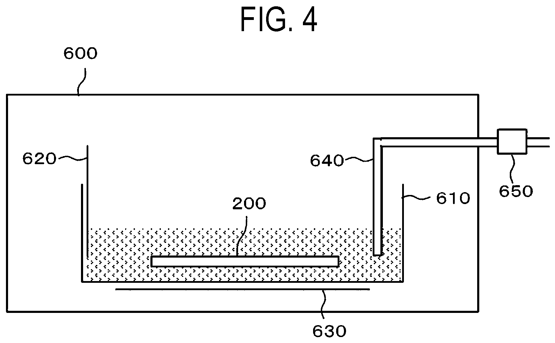

As shown in FIG. 4, the cleaning apparatus 600 includes a process tank 610. The process tank 610 is capable of accommodating one or more wafers 200. The processing solution supply pipe 640 is connected to a processing solution tank (not shown) via a liquid mass flow controller (LMFC) 650, and is configured to be capable of supplying a processing solution into the process tank 610. The process tank 610 stores the processing solution for exposure, and the wafers 200 are immersed in the processing solution. The processing solution supply pipe 640 and the LMFC 650 constitute a processing solution supply system that supplies the processing solution to the wafers 200. The processing solution supply system may further include the process tank 610. The cleaning apparatus 600 includes a temperature sensor 620 that detects a temperature of the processing solution and a heater 630 that regulates the temperature of the processing solution. The temperature sensor 620 is installed along an inner wall of the process tank 610. The heater 630 is disposed near the process tank 610 and is configured to keep the processing solution in the process tank 610 at an appropriate temperature based on the temperature sensor 620.

### (iii) Configuration of Transfer Chamber 700

As shown in FIG. 1, the transfer chamber 700 is configured between the film-forming apparatus 500 and the cleaning apparatus 600. A transferrer 750 for transferring the wafer 200 is provided in the transfer chamber 700. The transferrer 750 transfers the wafer 200 between the film-forming apparatus 500 and the cleaning apparatus 600 by holding the wafer 200 on a substrate mount installed on an arm.

### (iv) Controller

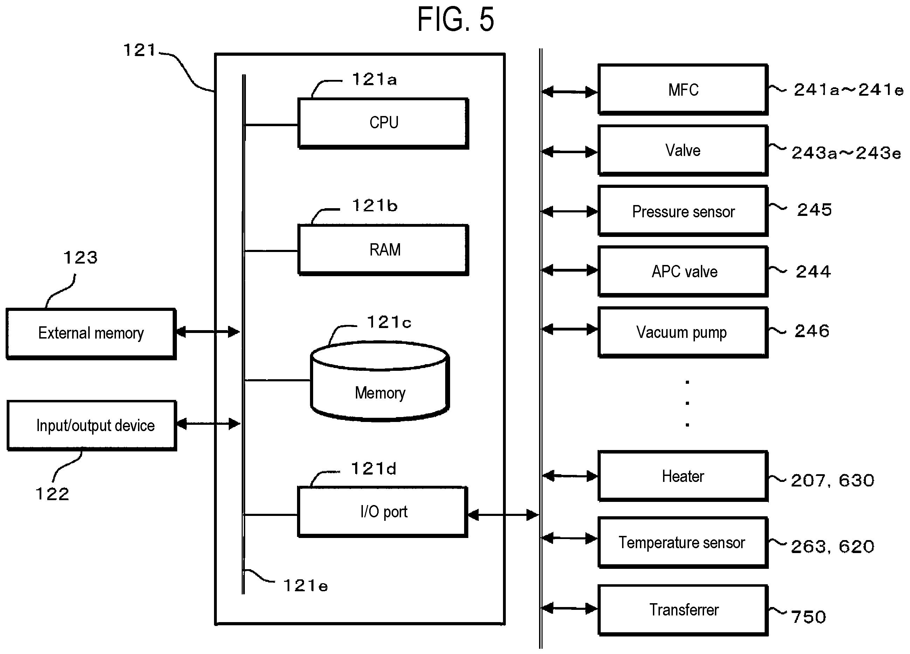

As shown in FIG. 5, the controller 121 as a control part (control means) of the film-forming apparatus 500, the cleaning apparatus 600 and the transfer chamber 700 is configured as a computer including a CPU (Central Processing Unit) 121a, a RAM (Random Access Memory) 121b, a memory 121c and an I/O port 121d. The RAM 121b, the memory 121c and the I/O port 121d are configured to be capable of exchanging data with the CPU 121a via an internal bus 121e. An input/output device 122 configured as, for example, a touch panel or the like is connected to the controller 121. In addition, an external memory 123 may be connected to the controller 121. The substrate processing apparatus 100 may be configured to include one controller or a plurality of controllers. That is, control for performing a processing sequence described later may be performed using one controller or a plurality of controllers. The plurality of controllers may be configured as a control system in which the controllers are connected to each other via a wired or wireless communication network, and the control for performing the processing sequence described later may be performed by the entire control system. When the term "controller" is used in the present disclosure, it may include one controller, a plurality of controllers, or a control system configured by a plurality of controllers.

The memory 121c is composed of, for example, a flash memory, a HDD (Hard Disk Drive), a SSD (Solid State Drive), or the like. In the memory 121c, there are readably recorded and stored a control program for controlling an operation of the substrate processing apparatus 100, a process recipe in which procedures and conditions of a substrate processing procedure to be described later are written, and the like. The process recipe is a combination that causes the controller 121 to execute respective procedures in the below-described substrate processing in the substrate processing apparatus 100 so as to obtain a predetermined result. The process recipe functions as a program. Hereinafter, the process recipe, the control program and the like are collectively and simply referred to as a program (program product). Further, the process recipe is also simply referred to as a recipe. When the term "program" is used herein, it may mean a case of solely including the recipe, a case of solely including the control program, or a case of including both the recipe and the control program. The RAM 121b is configured as a memory area (work area) in which programs, data and the like read by the CPU 121a are temporarily held.

The I/O port 121d is connected to the above-mentioned MFCs 241a to 241e, the valves 243a to 243e, the pressure sensor 245, the APC valve 244, the vacuum pump 246, the temperature sensors 263 and 620, the heaters 207 and 630, the transferrer 750, and the like.

The CPU 121a is configured to be capable of reading a control program from the memory 121c and executing the control program, and is configured to be capable of reading a recipe from the memory 121c in response to an input of an operation command from the input/output device 122, etc. The CPU 121a is configured to be capable of, according to contents of the read recipe, controlling the flow rate regulating operations for various substances (various gases) by the MFCs 241a to 241e, the opening/closing operations of the valves 243a to 243e, the opening/closing operation of the APC valve 244 and the pressure regulating operation by the APC valve 244 based on the pressure sensor 245, the start and stop of the vacuum pump 246, the temperature regulating operations of the heaters 207 and 630 based on the temperature sensors 263 and 620, the rotation and rotation speed adjusting operation of the boat 217 by the rotator 267, the raising/lowering operation of the boat 217 by the boat elevator 115, the opening/closing operation of the shutter 219s by the shutter opening/closing mechanism 115s, the operation of the transferrer 750, and the like.

The controller 121 may be configured by installing, on the computer, the above-described program recorded and stored in an external memory 123. The external memory 123 includes, for example, a magnetic disk such as a HDD or the like, an optical disk such as a CD or the like, a semiconductor memory such as a USB memory, a SSD, or the like, and so forth. The memory 121c and the external memory 123 are configured as a computer readable recording medium. Hereinafter, the memory 121c and the external memory 123 are collectively and simply referred to as a recording medium. As used herein, the term "recording medium" may refer to a case of solely including the memory 121c, a case of solely including the external memory 123, or a case of including both. The program may be provided to the computer by using communication means such as the Internet or a dedicated line without using the external memory 123.

### (2) Substrate Processing Process

A method of processing a substrate as a process of manufacturing a semiconductor device by using the above-described substrate processing apparatus 100, that is, a processing sequence example for forming a film on a first surface out of first and second surfaces of a wafer 200 as a substrate, is described below. In the embodiments, steps A, B, and C described below are performed in the named order. In step A, a wafer 200 is prepared that includes a first surface, which includes a first termination and constitutes at least a portion of an inner surface of a recess, and a second surface, which includes a second termination different from the first termination (preparation step). In step B, the wafer 200 is exposed to a processing solution containing a liquid that reacts with the first termination and an additive that reduces surface tension of the liquid, thereby selectively removing the first termination with respect to the second termination (removal step). In step C, a film is selectively formed on the first surface by supplying a film-forming agent to the wafer 200 (film-forming step). Step A is performed in the film-forming apparatus 500, step B in the cleaning apparatus 600, and step C in the film-forming apparatus 500. In the following description, the operation of each component of the substrate processing apparatus 100 is controlled by the controller 121.

In the present disclosure, the meaning of "selectively remove" and "selectively process" is not limited to the case where removal or processing is performed on one, and removal or processing is entirely not performed on the other. This meaning includes a case where an amount, speed, probability, and the like of removal or processing on one are relatively greater than an amount, speed, probability, and the like of removal or processing on the other. In other words, this meaning includes a case where removal or processing is performed preferentially on one over the other. Similarly, the meaning of "selectively form" and "selectively adsorb" is not limited to the case where formation or adsorption is performed on one, and formation or adsorption is entirely not performed on the other. This meaning includes a case where an amount, speed, probability, and the like of formation or adsorption on one are relatively greater than an amount, speed, probability, and the like of formation or adsorption on the other. In other words, this meaning includes a case where formation or adsorption is performed preferentially on one over the other.

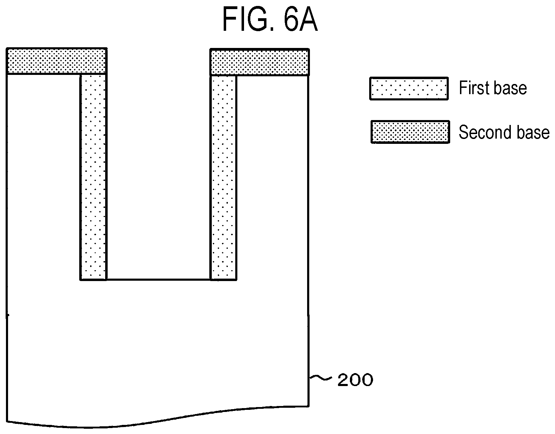

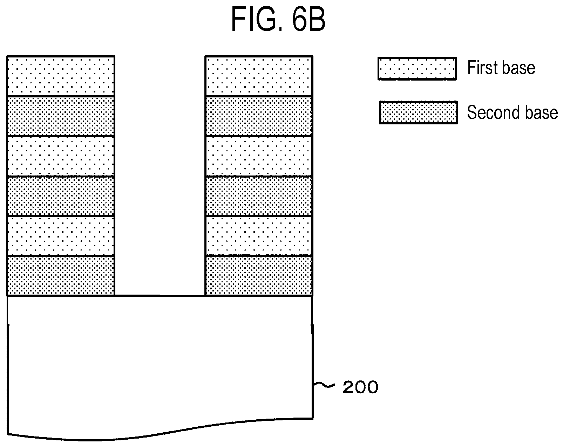

In the embodiments, an example of using a wafer 200 with a recess such as a trench, a groove, or a hole as a three-dimensional structure formed on its surface is described. The inner surface of the recess formed on the wafer 200 includes a first base and a second base. The first surface is formed by a surface of a region where the first base is formed, and the second surface is formed by a surface of a region where the second base is formed *(see* FIGS. 6A and 6B). On the inner surface of the recess, at least a region of the second surface is provided closer to an opening side than the first surface is. In the following, as an example, a case where the first base is a silicon oxide film (SiO film) and the second base is a silicon nitride film (SiN film) is described. In addition, the recess in the embodiments is formed in a shape in which at least one selected from the group of a width of an opening and a width of an inside (particularly a width at a portion where the width is minimum) is 100 µm or less, and a ratio of a length in a depth direction of the recess to the width of the opening (depth/width, i.e., aspect ratio) is 1 or more. In the following, particularly, a case is described where the widths of the opening and the inside of the recess are both 100 µm or less and the aspect ratio is 1 or more.

As described above, step A in the embodiments is:
(a) a step of preparing a wafer 200 including a first surface, which includes a first termination and constitutes at least a portion of an inner surface of a recess, and a second surface, which includes a second termination different from the first termination *(see* FIG. 7D).

In the embodiments, a case is described where in step A,
(a-1) step a1 of forming the first termination on the first surface by supplying a first modifying agent to the wafer 200,
(a-3) step a3 of forming a third termination on the second surface selectively with respect to the first surface, and
(a-2) step a2 of supplying a second modifying agent to the wafer 200 to allow the third termination to react with the second modifying agent to form the second termination on the second surface,
are performed in the named order *(see* FIGS. 7B to 7D).

In addition, in the embodiments, a case is described where in step a3, a cycle including
(a-3a) step a3a of supplying a precursor to the wafer 200, and
(a-3b) step a3b of supplying an oxidizing agent to the wafer 200
is performed a predetermined number of times (n1 times where n1 is an integer of 1 or 2 or more) to form an intermediate layer including a surface serving as the second surface on which the third termination is formed *(see* FIG. 7C).

As described above, step B in the embodiments is:
(b) a step of removing the first termination selectively with respect to the second termination by exposing the wafer 200 to a processing solution containing a liquid that reacts with the first termination and an additive that reduces surface tension of the liquid *(see* FIG. 7E).

As described above, step C in the embodiments is:
(c) a step of selectively forming a film on the first surface by supplying a film-forming agent to the wafer 200 after step B is performed *(see* FIG. 7F).

In addition, in the embodiments, a case is described where in step C, a cycle including
step c1 of supplying a precursor to the wafer 200 and step c2 of supplying an oxidizing agent to the wafer 200
is performed a predetermined number of times (n2 times where n2 is an integer of 1 or 2 or more) to form a film on the first surface.

In the present disclosure, the above-described processing sequence may be denoted as follows for the sake of convenience. The same notations are used in the following descriptions of modifications and other embodiments.

First modifying agent → (precursor → purging → oxidizing agent → purging) × n1 → second modifying agent → exposure to processing solution → (precursor → purging → oxidizing agent → purging) × n2

The term "wafer" used herein may refer to a wafer itself or a stacked body of the wafer and a predetermined layer or film formed on a surface of the wafer. The phrase "a surface of a wafer" used herein may refer to a surface of a wafer itself or a surface of a predetermined layer or the like formed on the wafer. The expression "a predetermined layer is formed on a wafer" used herein may mean that a predetermined layer is directly formed on a surface of a wafer itself or that a predetermined layer is formed on a layer or the like formed on the wafer. The term "substrate" used herein may be synonymous with the term "wafer."

As used herein, the term "agent" includes at least one selected from the group of a gaseous substance and a liquid substance. The liquid substance includes a mist-like substance. That is, each of the film-forming agent (precursor or oxidizing agent), the first modifying agent and the second modifying agent may include a gaseous substance, a liquid substance such as a mist-like substance, or both of them.

The term "layer" as used herein includes at least one selected from the group of a continuous layer and a discontinuous layer. For example, a first to sixth layers and the intermediate layer may include a continuous layer, a discontinuous layer, or both.

In the present disclosure, when the film-forming agent (precursor or oxidizing agent), the first modifying agent, and the second modifying agent are described as being adsorbed to or reacting with the surface of the wafer 200, this includes a case where they are adsorbed to or reacted with the surface of the wafer while remaining undecomposed, as well as a case where intermediates generated by decomposition thereof or by detachment of their ligands are adsorbed to or reacted with the surface of the wafer 200.

### (Wafer Charging and Boat Loading)

After a plurality of wafers 200 are charged to the boat 217 by the transferrer 750 (wafer charging), the shutter 219s is moved by the shutter opening/closing mechanism 115s to open the opening at the lower end of the manifold 209 (shutter opening). Then, as shown in FIG. 2, the boat 217 supporting the wafers 200 is lifted by the boat elevator 115 and loaded into the process chamber 201 (boat loading). In this state, the seal cap 219 seals the lower end of the manifold 209 via the O-ring 220b.

A SiO film as the first base and a SiN film as the second base are exposed on the surface of the wafer 200 charged to the boat 217. In the wafer 200, the first surface includes OH terminations as adsorption sites over an entire region thereof, whereas the second surface does not include OH terminations over a substantially entire region *(see* FIG. 7A).

### (Pressure Regulation and Temperature Regulation)

After the boat loading is completed, an inside of the process chamber 201, i.e., a space where the wafer 200 exists, is exhausted into vacuum (exhausted into a reduced pressure) by the vacuum pump 246 so that the pressure inside the process chamber 201 becomes a desired pressure (degree of vacuum). At this time, the pressure inside the process chamber 201 is measured by the pressure sensor 245, and the APC valve 244 is subjected to feedback control based on the measured pressure information. In addition, the wafer 200 in the process chamber 201 is heated by the heater 207 so that the wafer 200 reaches a desired processing temperature. At this time, the state of supply of electric power to the heater 207 is feedback-controlled based on the temperature information detected by the temperature sensor 263 so that the inside of the process chamber 201 achieves a desired temperature distribution. Further, the rotation of the wafer 200 by the rotator 267 is started. Moreover, the heater 630 is controlled based on temperature information detected by the temperature sensor 620 so that the processing solution in the process tank 610 reaches a desired temperature. The vacuum-exhaust of the process chamber 201, the heating and rotation of the wafer 200, and the regulation of the temperature of the processing solution are continuously performed at least until the processing on the wafer 200 is completed.

Thereafter, the following steps A, B, and C are executed in sequence. In step A, the following steps a1, a3, and a2 are executed in sequence.

### [Step A: Preparation Step]

### (Step a1)

In this step, the first modifying agent is supplied to the wafer 200 in the process chamber 201.

Specifically, the valve 243c is opened to allow the first modifying agent to flow into the gas supply pipe 232c. A flow rate of the first modifying agent is regulated by the MFC 241c. The first modifying agent is supplied into the process chamber 201 via the nozzle 249a and exhausted from the exhaust port 231a. At this time, the first modifying agent is supplied to the wafer 200 (first modifying agent supply). At this time, the valves 243d and 243e may be opened to supply an inert gas into the process chamber 201 via each of the nozzles 249a and 249b.

Processing conditions when supplying the first modifying agent in this step are exemplified as follows.
Processing temperature: 25 to 500 degrees C, particularly 50 to 300 degrees C
Processing pressure: 1 to 13,300 Pa, particularly 50 to 1,330 Pa
First modifying agent supply flow rate: 0.01 to 3 slm, particularly 0.5 to 1 slm
First modifying agent supply time: 0.1 seconds to 120 minutes, particularly 30 seconds to 60 minutes
Inert gas supply flow rate (per gas supply pipe): 0 to 20 slm

In the present disclosure, the expression of a numerical range such as "25 to 500 degrees C" means that the lower limit and the upper limit are included in the range. Therefore, for example, "25 to 500 degrees C" means "25 degrees C or more and 500 degrees C or less". The same applies to other numerical ranges. In the present disclosure, the processing temperature means the temperature of the wafer 200 or the temperature inside the process chamber 201, and the processing pressure means the pressure inside the process chamber 201, i.e., the pressure in the space in which the wafer 200 exists. In addition, a processing time means a time for which the processing continues. In addition, when the supply flow rate includes 0 slm, 0 slm means a case in which the substance is not supplied. These also hold true in the following descriptions.

By supplying the first modifying agent to the wafer 200 under the above-mentioned processing conditions, at least a portion of a molecular structure of a molecule constituting the first modifying agent is selectively (preferentially) adsorbed to the first surface to selectively form a first layer (first adsorption suppression layer) on the first surface. Specifically, while suppressing adsorption of at least a portion of the molecular structure of the molecule constituting the first modifying agent to the second surface, the OH termination formed on the first surface is reacted with the first modifying agent, and at least a portion of the molecular structure of the molecule constituting the first modifying agent is selectively adsorbed to the first surface. This makes it possible to terminate the first surface with at least a portion of the molecular structure of the molecule constituting the first modifying agent. Examples of at least a portion of the molecular structure of the molecules constituting the first modifying agent include a residue (e.g., Si-H) containing a bond between an atom (e.g., Si) that reacts with an OH termination and a hydrogen group (H group), or a residue (e.g., Si-OR) in which an atom that reacts with an OH termination is bonded to an alkoxy group. When the first surface is terminated with these residues, a H-termination or an alkoxy group is formed as the first termination on the first surface *(see* FIG. 7B). The first termination formed on the first surface acts as an inhibitor that inhibits adsorption of the precursor, the second modifying agent, and the film-forming agent to the first surface in steps a3, a2, and C described below.

The first modifying agent may be, for example, a substance in which hydrogen (H) and an amino group are bonded to Si, i.e., an aminosilane, such as tris(dimethylamino)silane (Si[N(CH₃)₂]₃H), bis(diethylamino)silane (Si[N(C₂H₅)₂]₂H₂), bis(tertiary-butylamino)silane (SiH₂[NH(C₄H₉)]₂), (diisopropylamino)silane (SiH₃[N(C₃H₇)₂]), (diisobutylamino)silane (SiH₃[N(C₄H₉)₂]), (diisopentylamino)silane (SiH₃[N(C₅H₁₁)₂]), or the like. In particular, it is desirable to use a substance in which three H atoms and one amino group are bonded to Si, i.e., a monoaminosilane, such as (diisobutylamino)silane, (diisopropylamino)silane, or the like. By using the monoaminosilane as the first modifying agent, it is possible to form a H termination more uniformly and sufficiently on the first surface in this step.

Furthermore, the first modifying agent may be, for example, a substance in which an alkoxy group and an amino group are bonded to Si, such as (dimethylamino)trimethoxysilane (Si(OCH₃)₃[N(CH₃)₂]), (dimethylamino)triethoxysilane (Si(OC₂H₅)₃[N(CH₃)₂]), (dimethylamino)triprotoxysilane (Si(OC₃H₇)₃[N(CH₃)₂]), (dimethylamino)tributoxysilane (Si(OC₄H₉)₃[N(CH₃)₂]), or the like. In particular, it is desirable to use a substance in which three alkoxy groups and one amino group are bonded to Si. By using such a substance as the first modifying agent, it is possible to form an alkoxy group termination more uniformly and sufficiently on the first surface in this step.

As the first modifying agent, one or more of these substances may be used.

The inert gas may be a nitrogen (N₂) gas, or a rare gas such as an argon (Ar) gas, a helium (He) gas, a neon (Ne) gas or a xenon (Xe) gas. One or more of these gases may be used as the inert gas. This also applies to each step described later.

After selectively forming the first termination on the first surface of the wafer 200 (the first surface constituting the inner surface of the recess), the valve 243c is closed to stop the supply of the first modifying agent into the process chamber 201. Then, the process chamber 201 is vacuum-exhausted to remove gaseous substances remaining in the process chamber 201 from the inside of the process chamber 201. At this time, the valves 243d and 243e are opened to supply an inert gas into the process chamber 201 through the nozzles 249a and 249b. The inert gas supplied from the nozzles 249a and 249b acts as a purge gas, thereby purging the space in which the wafer 200 exists, i.e., the process chamber 201 (purging).

Processing conditions when performing purging in step a1 are exemplified as follows.
Processing temperature: 25 to 500 degrees C, particularly 50 to 300 degrees C
Processing pressure: 1 to 1,330 Pa, particularly 1 to 400 Pa
Processing time: 1 to 120 seconds, particularly 1 to 60 seconds
Inert gas supply flow rate (per gas supply pipe): 0.5 to 10 slm, particularly 1 to 5 slm
Inert gas supply time: 1 to 120 seconds

### (Step a3)

After step a1 is completed, a precursor and an oxidizing agent are supplied to the wafer 200. This selectively forms an oxide layer (intermediate layer) on the second surface. In this step, specifically, the following steps a3a and a3b are executed in sequence.

### [Step a3a]

After step a1 is completed, a precursor is supplied to the wafer 200 in the process chamber 201, i.e., the wafer 200 available after the first termination is selectively formed on the first surface that constitutes the inner surface of the recess.

Specifically, the valve 243a is opened to allow the precursor to flow into the gas supply pipe 232a. A flow rate of the precursor is regulated by the MFC 241a. The precursor is supplied into the process chamber 201 via the nozzle 249a and exhausted from the exhaust port 231a. At this time, the precursor is supplied to the wafer 200 (precursor supply). At this time, the valves 243d and 243e may be opened to supply an inert gas into the process chamber 201 via each of the nozzles 249a and 249b.

Processing conditions when supplying the precursor in this step are exemplified as follows.
Processing temperature: room temperature to 600 degrees C, particularly 50 to 400 degrees C
Processing pressure: 1 to 101,325 Pa, particularly 1 to 1,300 Pa
Precursor supply flow rate: 0.001 to 2 slm, particularly 0.001 to 1 slm
Precursor supply time: 1 second to 240 minutes, particularly 30 seconds to 120 minutes Other processing conditions may be the same as the processing conditions when supplying the first modifying agent in step a1.

By supplying the precursor to the wafer 200 under the above-mentioned processing conditions, it is possible to selectively (preferentially) adsorb at least a portion of a molecular structure of a molecule constituting the precursor to the second surface on which the first termination is not formed, thus selectively forming a second layer on the second surface. At this time, adsorption of at least a portion of the molecular structure of the molecule constituting the precursor to the first surface is suppressed by an adsorption suppressing effect of the first termination formed on the first surface.

The precursor may be, for example, a Si-containing material containing silicon (Si) as a main element constituting the intermediate layer formed in step a3. The Si-containing material may be, for example, a material containing halogen and Si, i.e., halosilane. Halogen includes chlorine (Cl), fluorine (F), bromine (Br), iodine (I), and the like. The halosilane may be, for example, a material containing Cl and Si, i.e., chlorosilane.

The precursor may be, for example, chlorosilane such as monochlorosilane (SiH₃Cl), dichlorosilane (SiH₂Cl₂), trichlorosilane (SiHCl₃), tetrachlorosilane (SiCl₄), hexachlorodisilane (Si₂Cl₆), octachlorotrisilane (Si3Cl₈), or the like.

In addition to the chlorosilane, the precursor may also be, for example, fluorosilane such as tetrafluorosilane (SiF₄), difluorosilane (SiH₂F₂) or the like, bromosilane such as tetrabromosilane (SiBr₄), dibromosilane (SiH₂Br₂) or the like, and iodosilane such as tetraiodosilane (SiI₄), diiodosilane (SiH₂I₂) or the like.

In addition to these substances, the precursor may also be, for example, a substance containing an amino group and Si, i.e., aminosilane. The amino group is a monovalent functional group obtained by removing H from ammonia, a primary amine or a secondary amine, and may be represented as -NH₂, -NHR, or -NR₂. R represents an alkyl group, and the two Rs in -NR₂ may be the same or different.

The precursor may also be, for example, aminosilane such as tetrakis(dimethylamino)silane (Si[N(CH₃)₂]₄), tris(dimethylamino)silane, bis(diethylamino)silane (Si[N(C₂H₅)₂]₂H₂), bis(tertiary-butylamino)silane (SiH₂[NH(C₄H₉)]₂), (diisopropylamino)silane (SiH₃[_{N}(C₃H₇)₂]), or the like.

As the precursor, one or more of these substances may be used.

After selectively forming the second layer on the second surface of the wafer 200 (the second surface constituting the inner surface of the recess), the valve 243a is closed to stop the supply of the precursor into the process chamber 201. Then, gaseous substances remaining in the process chamber 201 are removed from the inside of the process chamber 201 by using the same processing procedure and processing conditions as those for purging in step a1 (purging).

### [Step a3b]

After step a3a is completed, an oxidizing agent is supplied to the wafer 200 in the process chamber 201, i.e., the wafer 200 available after the second layer is selectively formed on the second surface that constitutes the inner surface of the recess.

Specifically, the valve 243b is opened to allow the oxidizing agent to flow into the gas supply pipe 232b. A flow rate of the oxidizing agent is regulated by the MFC 241b. The oxidizing agent is supplied into the process chamber 201 via the nozzle 249b and exhausted from the exhaust port 231a. At this time, the oxidizing agent is supplied to the wafer 200 (oxidizing agent supply). At this time, the valves 243d and 243e may be opened to supply an inert gas into the process chamber 201 via each of the nozzles 249a and 249b.

Processing conditions when supplying the oxidizing agent in this step are exemplified as follows.
Processing temperature: room temperature to 600 degrees C, particularly 50 to 400 degrees C
Processing pressure: 1 to 101,325 Pa, particularly 1 to 1,300 Pa
Oxidizing agent supply flow rate: 0.001 to 20 slm, particularly 0.001 to 10 slm
Oxidizing agent supply time: 1 second to 240 minutes, particularly 30 seconds to 120 minutes
Other processing conditions may be the same as the processing conditions when the first modifying agent is supplied in step a1.

By supplying the oxidizing agent to the wafer 200 under the above-mentioned processing conditions, it is possible to oxidize at least a portion of the second layer formed on the second surface in step a3a. As a result, a third layer, obtained by oxidizing the second layer and forming a termination of an OH group (hydroxyl group) (OH termination) on the surface, is formed on the second surface.

The oxidizing agent may be, for example, an oxygen (O)-containing substance. The O-containing substance may be, for example, oxygen (O₂), ozone (O₃), nitrous oxide (N₂O), nitric oxide (NO), nitrogen dioxide (NO₂), carbon monoxide (CO), carbon dioxide (CO₂), and the like. As the oxidizing agent, one or more of these substance may be used.

Moreover, the oxidizing agent may be, for example, an O- and H-containing substance. The O- and H-containing substance may be, for example, water vapor (H₂O), hydrogen peroxide (H₂O₂), H₂ + O₂, H₂ + O₃, and the like. That is, the O- and H-containing substance may also be an O-containing substance + H-containing substance. In this case, a deuterium (D)-containing substance may also be used instead of the H-containing substance. Deuterium (D₂) may also be used as the D-containing substance. One or more of these substances may be used as the oxidizing agent.

In the present disclosure, a combined description such as "H₂ + O₂" means a mixture of H₂ and O₂. When supplying a mixture, two substances may be mixed (premixed) in a supply pipe and then supplied into the process chamber 201, or two substances may be separately supplied into the process chamber 201 through different supply pipes and mixed (post-mixed) in the process chamber 201.

After the second layer selectively formed on the second surface of the wafer 200 (the second surface constituting the inner surface of the recess) is changed to the third layer, the valve 243b is closed to stop the supply of the oxidizing agent into the process chamber 201. Then, gaseous substances remaining in the process chamber 201 are removed from the inside of the process chamber 201 by the same processing procedure and processing conditions as those for purging in step a1 (purging).

### [Performing a Predetermined Number of Times]

A cycle of performing the above-mentioned steps a3a and a3b non-simultaneously, i.e., without synchronization, in the named order is performed n1 times (where n1 is an integer of 1 or 2 or more), so that the intermediate layer is selectively formed on the second surface of the wafer 200. For example, when the above-mentioned precursor and oxidizing agent are used, for example, it is possible to selectively form a SiO layer as an intermediate layer on the second surface. In this way, it is possible to form an OH termination as a third termination on the second surface selectively with respect to the first surface *(see* FIG. 7C). This makes it possible to form an intermediate layer with a surface serving as a second surface on which an OH termination is formed *(see* FIG. 7C). The third termination such as an OH termination formed on the second surface acts as an adsorption site for the second modifying agent supplied in step a2 described later. In other words, the intermediate layer with the third termination acts as an adsorption promoting layer for the second modifying agent. It is desirable to repeat the above-mentioned cycle multiple times. In other words, it is desirable that a thickness of the third layer formed per cycle is set to be thinner than a desired film thickness, and the above-mentioned cycle is repeated multiple times until a film thickness of the intermediate layer formed by stacking the third layer reaches the desired film thickness.

### (Step a2)

After step a3 is completed, the second modifying agent is supplied to the wafer 200 in the process chamber 201, i.e., the wafer 200 available after the third termination is selectively formed on the second surface that constitutes the inner surface of the recess.

Specifically, the valve 243c is opened to allow the second modifying agent to flow into the gas supply pipe 232c. A flow rate of the second modifying agent is regulated by the MFC 241c. The second modifying agent is supplied into the process chamber 201 through the nozzle 249a and exhausted from the exhaust port 231a. At this time, the second modifying agent is supplied to the wafer 200 (second modifying agent supply). At this time, the valves 243d and 243e may be opened to supply an inert gas into the process chamber 201 through each of the nozzles 249a and 249b.

Processing conditions when supplying the second modifying agent in this step are exemplified as follows.
Processing temperature: room temperature (25 degrees C) to 500 degrees C, particularly room temperature to 250 degrees C
Processing pressure: 5 to 2,000 Pa, particularly 10 to 1,000 Pa
Second modifying agent supply flow rate: 1 to 3 slm, particularly 1 to 0.5 slm
Second modifying agent supply time: 1 second to 120 minutes, particularly 30 seconds to 60 minutes
Other processing conditions may be the same as the processing conditions when the first modifying agent is supplied in step a1.

By supplying the second modifying agent to the wafer 200 under the above-mentioned processing conditions, it is possible for at least a portion of a molecular structure of a molecule constituting the second modifying agent to be selectively adsorbed to the second surface, making it possible to selectively form a fourth layer (second adsorption suppression layer) on the second surface. Specifically, while suppressing adsorption of at least a portion of the molecular structure of the molecule constituting the second modifying agent to the first surface, the third termination formed on the second surface reacts with the second modifying agent, making it possible to selectively adsorb at least a portion of the molecular structure of the molecule constituting the second modifying agent to the second surface. This makes it possible to terminate the second surface with at least a portion of the molecular structure of the molecule constituting the second modifying agent. The at least a portion of the molecular structure of the molecule constituting the second modifying agent may be, for example, a residue including a bond between an atom (e.g., Si) that reacts with the third termination and an alkyl group (e.g., a methyl group (Me group), an ethyl group (Et group), or a tert-butyl group (tert-Bu group)). More specifically, such a residue may be, for example, a trimethylsilyl group (Si-Me3), a triethylsilyl group (Si-Et3), a tert-butyldimethylsilyl group (Si-(CH₃)₂C(CH₃)₃), or the like. In this case, the Si constituting these silyl groups contained in the second modifying agent bonds with the O of the OH termination (OH group) on the second surface, and an alkyl group termination is formed as a second termination on the second surface *(see* FIG. 7D). The second termination such as the alkyl group termination formed on the second surface acts as an inhibitor that inhibits adsorption of the film-forming agent to the second surface in step C described below.

The first termination formed on the first surface and the second termination formed on the second surface are both terminations that impart hydrophobicity to the surfaces on which they are formed. Furthermore, in the first termination such as an H termination or the like and the second termination such as an alkyl group termination or the like, the second termination is more hydrophobic than the first termination, and therefore the second surface on which the second termination is formed is more hydrophobic than the first surface on which the first termination is formed. The expression "more hydrophobic" as used herein may also be expressed as "more water repellent" or "less hydrophilic."

The first termination reacts with the processing solution to which the wafer 200 is exposed in step C described later, and is consequently removed from the first surface. On the other hand, compared to the first termination, the second termination is less likely to react with the processing solution and is less likely to be removed from the second surface. That is, the first termination reacts more easily with the processing solution and is more likely to be selectively removed than the second termination.

For example, as shown in FIG. 6A, on the inner surface of the recess, the second surface is provided closer to the opening side than the first surface. Therefore, on the inner surface of the recess available after step a2 is completed, the second surface on which the second termination is formed is provided closer to the opening side than the first surface on which the first termination is formed.

The second modifying agent may be, for example, a substance in which an amino group and an alkyl group are bonded to Si, i.e., alkylaminosilane, such as (dimethylamino)trimethylsilane ((CH₃)₂NSi(CH₃)₃), (diethylamino)triethylsilane ((C₂H₅)₂NSi(C₂H₅)₃), (dimethylamino)triethylsilane ((CH₃)₂NSi(C₂H₅)₃), (diethylamino)trimethylsilane ((C₂H₅)₂NSi(CH₃)₃), (diisopropylamino)trimethylsilane ((C₃H₇)₂NSi(CH₃)₃), or the like. In particular, the second modifying agent may desirably be a substance in which three alkyl groups and one amino group are bonded to Si, i.e., a trialkylaminosilane, such as (dimethylamino)trimethylsilane, (diethylamino)triethylsilane, or the like. As the second modifying agent, one or more of these substances may be used.

After selectively forming the second termination on the second surface of the wafer 200 (the second surface constituting the inner surface of the recess), the valve 243c is closed to stop the supply of the second modifying agent into the process chamber 201. Then, gaseous substances remaining in the process chamber 201 are removed from the inside of the process chamber 201 by the same processing procedure and processing conditions as those for purging in step a1 (purging).

### (After-Purge and Atmospheric Pressure Restoration)

After step a2 is completed, an inert gas is supplied as a purge gas from each of the nozzles 249a and 249b into the process chamber 201 and exhausted from the exhaust port 231a. Thus, the inside of the process chamber 201 is purged, and gaseous substances remaining in the process chamber 201 are removed from the inside of the process chamber 201 (after-purge). Thereafter, the atmosphere in the process chamber 201 is replaced with an inert gas (inert gas replacement), and the pressure in the process chamber 201 is returned to the atmospheric pressure (atmospheric pressure restoration).

### (Boat Unloading and Wafer Discharging)

Thereafter, the seal cap 219 is lowered by the boat elevator 115, and the lower end of the manifold 209 is opened. Then, the wafers 200 are unloaded from the lower end of the manifold 209 to an outside of the reaction tube 203 while being supported by the boat 217 (boat unloading). After the boat unloading, the shutter 219s is moved, and the opening at the lower end of the manifold 209 is sealed by the shutter 219s via the O-ring 220c (shutter closing). After the wafers 200 are unloaded to the outside of the reaction tube 203, they are taken out from the boat 217 by the transferrer 750 (wafer discharging).

The wafer 200 taken out by the transferrer 750 includes the first termination formed on the first surface and the second termination formed on the second surface *(see* FIG. 7D).

The wafer 200 taken out from the boat 217 by the transferrer 750 is transferred through the transfer chamber 700 and placed on a mounting table (not shown) provided in the cleaning apparatus 600.

### [Step B: Removal Step]

In this step, the wafer 200 is exposed to the processing solution supplied through the supply pipe 640 and stored in the process tank 610.

Specifically, by using a mover (not shown) provided in the cleaning apparatus 600, the wafer 200 placed on the mounting table in the cleaning apparatus 600 is immersed in the processing solution stored in the process tank 610 (i.e., the processing solution is supplied to the wafer 200).

Processing conditions for exposure to the processing solution in this step are exemplified as follows.
Exposure temperature: 0 to 100 degrees C, preferably 15 to 50 degrees C
Exposure time: 1 second to 120 minutes, preferably 30 seconds to 60 minutes

In the present disclosure, the exposure temperature refers to the temperature of the wafer 200 in the processing solution or the temperature of the processing solution, and the exposure time refers to a time during which the exposure continues.

By exposing the wafer 200 to the processing solution under the above-mentioned processing conditions, it is possible to selectively remove (detach/destroy) the first termination formed on the first surface with respect to the second termination formed on the second surface. Specifically, it is possible to remove the first termination formed on the first surface while leaving the second termination formed on the second surface *(see* FIG. 7E). More specifically, in step C described below, it is possible to remove the first termination that inhibits adsorption of the film-forming agent onto the first surface while leaving the second termination that inhibits the adsorption of the film-forming agent onto the second surface.

The processing solution is a liquid which contains a liquid that reacts with the first termination and an additive that reduces the surface tension of the liquid. The additive for reducing the surface tension of the liquid that reacts with the first termination possesses a surface tension smaller than that of the liquid that reacts with the first termination, or exhibits an effect of reducing the surface tension of the liquid that reacts with the first termination by being mixed with the liquid that reacts with the first termination. By containing the liquid that reacts with the first termination and the additive, the processing solution becomes a liquid that possesses a surface tension smaller than that of the liquid that reacts with the first termination.

The liquid that reacts with the first termination may be, for example, a liquid of a compound containing an OH termination in a molecule thereof, such as H₂O, H₂O₂, or the like. In particular, when the first termination contains a H termination, liquids of these compounds are suitably used as the liquid that reacts with the first termination. As the liquid that reacts with the first termination, one or more of these substances may be used. In addition, by using the liquid of the compound containing an OH termination in the molecule thereof as the liquid that reacts with the first termination, it is possible to replace the reacted H termination with an OH termination.

In addition, for example, a liquid containing H₂O may be used as the liquid that reacts with the first termination, and a liquid further containing H₂O₂ (i.e., a liquid called a hydrogen peroxide solution) may be used as the processing solution. By using the liquid further containing H₂O₂ as the processing solution, it is possible to further enhance an effect of removing the first termination formed on the first surface.

The additive may be, for example, a compound containing a substance with a structural formula R-COH, such as alkyl ethers such as polyoxyethylene alkyl ether and the like, polyhydric alcohol ethers such as alkyl glycoside and the like, fatty acid esters such as sorbitan fatty acid ester and the like, etc. R as used herein may be at least one selected from the group of carbon (C), hydrogen (H), oxygen (O), nitrogen (N), and fluorine (F), or at least one selected from the group of C, H, and O.

Furthermore, the additive may contain, for example, a compound in which one or more H atoms of an alkane (particularly a paraffin-based hydrocarbon) represented by CₘH₍₂ₘ₊₂₎ or an alkene (particularly an olefin-based hydrocarbon) represented by CₘH₂ₘ are substituted with OH (i.e., a compound called an alcohol).

In addition, the additive may contain, for example, at least one selected from the group of the compound in which one or more H atoms of an alkane (particularly a paraffin-based hydrocarbon) represented by CₘH₍₂ₘ₊₂₎ or an alkene (particularly an olefin-based hydrocarbon) represented by CₘH₂ₘ are substituted with OH, and a compound in which one or more H atoms of an aromatic hydrocarbon are substituted with OH (i.e., a compound called a phenol).

Moreover, the additive may contain, for example, a compound represented by CRₘ(OH)₍₄₋ₘ₎ (wherein R = CₙH₍₂ₙ₊₂₎ or CₙH₂ₙ).

In addition, the additive may contain, for example, one or more compounds selected from the group of methanol, ethanol, propanol, butanol, and ethylene glycol. Even when ethanol with an alcohol concentration of about 100% is used as the additive, H₂O may be contained in the ethanol as an impurity. H₂O as an impurity may act as the liquid that reacts with the first termination in the processing solution.

In addition to the additives mentioned above, any surfactant that reduces the surface tension of the liquid that reacts with the first termination may be used.

A concentration of the additive in the processing solution or a ratio of the liquid that reacts with the first termination to the additive, is desirably regulated based on at least one selected from the group of (i) hydrophobicity of at least one selected from the group of the first termination and the second termination, (ii) a width of at least one selected from the group of the opening and the inside of the recess (particularly the width at the portion where the width is minimum), and (iii) the aspect ratio of the recess. Specifically, for example, the greater the hydrophobicity of at least one selected from the group of the first termination and the second termination, the more the concentration of the additive may be regulated to be high. Further, the smaller the width of at least one selected from the group of the opening and the inside of the recess, the more the concentration of the additive may be regulated to be high. In addition, the greater the aspect ratio of the recess, the more the concentration of the additive may be regulated to be high. In particular, when the second surface on which the second termination is formed is located closer to the opening side than the first surface on which the first termination is formed, it is desirable to regulate the concentration of the additive based on the size of the second termination so that it becomes a concentration where the processing solution is possible to penetrate into the portion where the second termination is formed.

For example, when water is used as the liquid that reacts with the first termination and ethanol is used as the additive, the concentration of the additive in the processing solution is, for example, 0.1 to 99.9%, particularly 10 to 90%. In addition, the concentration of the additive is, for example, a concentration at which a contact angle θ of the processing solution with the surface terminated with the first termination or the second termination is 10 to 100°, particularly 10 to 90°.

After selectively removing the first termination on the first surface of the wafer 200 (the first surface constituting the inner surface of the recess), the wafer 200 is lifted from the process tank 610 by the mover and placed on a mounting table in the cleaning apparatus 600. The transferrer 750 transfers the wafer 200 placed on the mounting table from the cleaning apparatus 600 and loads the wafer 200 into the boat 217 via the transfer chamber 700.

### (Wafer Charging and Boat Loading)

Then, the wafers 200 are charged to the boat 217 and loaded into the process chamber 201 in the same manner as the wafer charging and boat loading described above.

### (Pressure Regulation and Temperature Regulation)

Thereafter, the pressure and temperature in the process chamber 201 are regulated by the same procedures as those for the pressure regulation and temperature regulation described above.

### [Step C: Film-Forming Step]

In this step, a film-forming agent is supplied to the wafer 200. This selectively forms a film on the first surface. Specifically, in this step, the following steps c1 and c2 are performed in sequence.

### [Step c1]

After step B is completed, a precursor is supplied to the wafer 200 that is loaded from the cleaning apparatus 600 into the process chamber 201 of the film-forming apparatus 500, that is, the wafer 200 available after the first termination on the first surface that constitutes the inner surface of the recess is selectively removed. In this step, the precursor may be supplied to the wafer 200 by the same processing procedure and processing conditions as those for supplying the precursor in step a3a.

By supplying the precursor to the wafer 200 under the above-mentioned processing conditions, it is possible to selectively form a fifth layer on the first surface by selectively adsorbing at least a portion of a molecular structure of a molecule constituting the precursor to the first surface from which the first termination is removed. At this time, adsorption of at least a portion of the molecular structure of the molecule constituting the precursor to the second surface is suppressed by an adsorption suppression effect of the second termination formed on the second surface. The first surface from which the H termination is removed is desirably a surface on which an OH termination is formed in place of the H termination in step B.

In addition, the precursor supplied to the wafer 200 in this step may be a gas containing one or more of the gases given as the examples of the precursor supplied to the wafer 200 in step a3a. The precursor used in this step may be the same as or different from the precursor used in step a3a.

After the fifth layer is selectively formed on the first surface of the wafer 200 (the first surface constituting the inner surface of the recess), the valve 243a is closed to stop the supply of the precursor into the process chamber 201. Then, gaseous substances remaining in the process chamber 201 are removed from the process chamber 201 by the same processing procedure and processing conditions as those for purging in step a1 (purging).

### [Step c2]

After step c1 is completed, an oxidizing agent is supplied to the wafer 200 in the process chamber 201, i.e., the wafer 200 available after the fifth layer is selectively formed on the first surface that constitutes the inner surface of the recess. In this step, the oxidizing agent may be supplied to the wafer 200 by the same processing procedure and processing conditions as those for supplying the oxidizing agent in step a3b.

By supplying the oxidizing agent to the wafer 200 under the above-mentioned processing conditions, it is possible to oxidize at least a portion of the fifth layer formed on the first surface in step c1. As a result, a sixth layer obtained by oxidizing the fifth layer and foming an OH termination on a surface thereof is formed on the first surface.

In addition, the oxidizing agent supplied to the wafer 200 in this step may be a gas containing one or more of the gases given as the examples of the oxidizing agent supplied to the wafer 200 in step a3b. The oxidizing agent used in this step may be the same as or different from that used in step a3b.

After the fifth layer formed on the first surface of the wafer 200 (the first surface constituting the inner surface of the recess) is changed to the sixth layer, the valve 243b is closed to stop the supply of the oxidizing agent into the process chamber 201. Then, gaseous substances remaining in the process chamber 201 are removed from the process chamber 201 by the same processing procedure and processing conditions as those for purging in step a1 (purging).

### [Performing a Predetermined Number of Times]

A cycle of performing the above-mentioned steps c1 and c2 in the named order asynchronously, i.e., without synchronization, is performed n2 times (where n2 is an integer of 1 or 2 or more), so that a film is selectively formed on the first surface of the wafer 200 (*see* FIG. 7F. It is desirable to repeat the above-mentioned cycle multiple times. In other words, it is desirable that a thickness of the sixth layer formed per cycle is set to be thinner than a desired film thickness, and the above-mentioned cycle is repeated multiple times until the film formed by stacking the sixth layer reaches the desired film thickness.

### (After-Purge and Atmospheric Pressure Restoration)

After step C is completed, the process chamber 201 is purged and the pressure in the process chamber 201 is returned to the atmospheric pressure by using the same procedure as in the after-purge and atmospheric pressure restoration described above.

### (Boat Unloading and Wafer Discharging)

Thereafter, by the same procedure as the boat unloading and wafer discharging described above, the wafers 200 are unloaded from the reaction tube 203 and taken out from the boat 217.

### (3) Effects of the Present Embodiments

The present embodiments provide one or more of the following effects.
(a) In step B, the wafer 200 including the first surface, which includes the first termination and constitutes at least a portion of the inner surface of the recess, and the second surface, which includes the second termination different from the first termination, is exposed to the processing solution containing the liquid that reacts with the first termination and the additive that reduces the surface tension of the liquid. In this way, by exposing the wafer 200 to the processing solution containing the liquid that reacts with the first termination and the additive that reduces the surface tension of the liquid, it is possible to selectively remove the first termination formed on the inner surface of the recess with respect to the second termination, and perform selective processing on the first surface. Specifically, by exposing the wafer 200 to the processing solution containing the liquid that reacts with the first termination and the additive with a smaller surface tension than the liquid, it is possible to spread the processing solution widely inside the recess, compared to a case of exposing the wafer 200 solely to the liquid that reacts with the first termination without the additive, thus making it possible to selectively remove the first termination formed on the inner surface of the recess. By selectively removing the first termination formed on the first surface, it is possible to perform a selective processing, for example, a film-forming process, on the first surface.
(b) In step B, by using the processing solution containing the liquid that reacts with the first termination and the additive with a surface tension lower than that of the liquid, it is possible to spread the processing solution throughout the inside of the recess. Therefore, it is possible to selectively remove the first termination even when the second surface on which the second termination with a higher hydrophobicity than the first termination is formed is provided closer to the opening than the first surface with the first termination, on the inner surface of the recess.
(c) When the first termination is formed on the inner surface of the recess in which at least one selected from the group of the opening and the inside possesses a width of 100 µm or less, even if the wafer 200 is exposed to the liquid (e.g., water) that reacts with the first termination and does not contain an additive, it may be difficult to widely spread the processing solution inside the recess. In particular, when at least one selected from the group of the opening and the inside includes a hydrophobic termination formed on the surface thereof and/or the aspect ratio of the recess is 1 or more, such a problem becomes prominent. In step B, by using the processing solution which contains the liquid that reacts with the first termination and the additive with a smaller surface tension than the liquid, even if the first termination is formed on the inner surface of the recess in which at least one selected from the group of the opening and the inside possesses a width of 100 µm or less, the processing solution is still possible spread throughout the inside of the recess. In particular, even if the first termination is formed on the inner surface of the recess in which the opening is formed with a width of 100 µm or less, the processing solution is still possible to spread throughout the inside of the recess.

The above-mentioned problem becomes more prominent under at least any of the following conditions (i) and (ii). Therefore, under such conditions, it is more desirable to use the embodiments in order to widely spread the processing solution inside the recess.
(i) The width of at least one selected from the group of the opening and the inside is 50 µm or less. The problem is more prominent if the width is 10 µm or less.
(ii) The aspect ratio of the recess is 2 or more. The problem is more prominent if the aspect ratio is 10 or more.

(d) In step C, the film-forming agent is supplied to the wafer 200 after performing step B. Therefore, it is possible to selectively form a film on the first surface.

(e) The second termination inhibits adsorption of the film-forming agent to the second surface. Therefore, in step C, it is possible to selectively form a film on the first surface.

(f) In step B, the first termination that inhibits adsorption of the film-forming agent onto the first surface is removed. Therefore, in step C, it is possible to selectively form a film on the first surface.

(g) In step B, by using a liquid of a compound containing an OH termination in its molecule as the liquid that reacts with the first termination, for example, the H termination as the first termination formed on the first surface may be efficiently removed. Therefore, in step C, it is possible to selectively form a film on the first surface.

(h) The second surface on which the second termination is formed is more hydrophobic than the first surface on which the first termination is formed. Therefore, in step B, it is possible to more selectively remove the first termination with respect to the second termination. As a result, in step C, possible to selectively form a film on the first surface.

(i) The concentration of the additive contained in the processing solution may be regulated depending on the hydrophobicity of the second termination. When the processing solution is not able to penetrate into the recess due to high hydrophobicity of the second termination, it is desirable to regulate the concentration of the additive so as to increase to a concentration at which the processing solution is able to penetrate into the recess. In addition, the concentration of the additive contained in the processing solution may be regulated depending on the width of the portion at the smallest width in the recess. When the minimum width in the recess is small and the processing solution is not able to penetrate into the portion at the smallest width, it is desirable to regulate the concentration of the additive so as to increase to a concentration at which the processing solution is able to penetrate into the portion at the smallest width. However, the higher is the concentration of the additive, the lower is the concentration of the liquid that reacts with the first termination. Therefore, it is desirable to set the concentration of the additive to a value equal to or not significantly exceeding a minimum value of the concentration of the additive that allows the processing solution to penetrate into the portion at the smallest width in the recess.

### <Other Embodiments of the Present Disclosure>

The embodiments of the present disclosure are specifically described above. However, the present disclosure is not limited to the above-described embodiments, and may be changed in various ways without departing from the spirit of the present disclosure.

For example, in the above-described embodiments, the case where the predetermined element contained in the precursor is Si is described as an example. However, the present disclosure is not limited to such embodiments. For example, the predetermined element may be a metal element such as titanium (Ti), zirconium (Zr), hafnium (Hf), tantalum (Ta), niobium (Nb), aluminum (Al), molybdenum (Mo), tungsten (W), germanium (Ge), or the like. In these cases, a metal oxide film such as a titanium oxide film (TiO film), a zirconium oxide film (ZrO film), a hafnium oxide film (HfO film), a tantalum oxide film (TaO film), a niobium oxide film (NbO film), an aluminum oxide film (AlO film), a molybdenum oxide film (MoO film), a tungsten oxide film (WO film), or a germanium oxide film (GeO film) is formed. In this embodiment, it is possible to obtain the same effects as those of the above-described embodiments.

For example, in the above-described embodiments, the case where the first surface (first base) is a SiO film and the second surface (second base) is a SiN film is described as an example. However, the present disclosure is not limited to such embodiments. For example, each of the first surface and the second surface may be a film containing a semiconductor element such as a silicon oxycarbonitride film (SiOCN film), a SiOC film, a silicon oxynitride film (SiON film), a SiCN film, a silicon carbide film (SiC film), a silicon borocarbonitride film (SiBCN film), a silicon boronitride film (SiBN film), a silicon borocarbide film (SiBC film), a silicon film (Si film), a germanium film (Ge film), a silicon germanium film (SiGe film) or the like, a film containing a metal element such as a titanium nitride film (TiN film), a tantalum nitride film (TaN film), a tungsten film (W film), a molybdenum film (Mo film), a ruthenium film (Ru film), a cobalt film (Co film), a nickel film (Ni film), a copper film (Cu film) or the like, an amorphous carbon film (a-C film), or a monocrystalline Si film (Si wafer), etc. Any base on which the first termination is able to be formed may be used as the first base (first surface). Any base on which the second termination is able to be formed may be used as the second base (second surface). In this embodiment, it is possible to obtain the same effects as those of the above-described embodiments.

For example, in the above-described embodiments, the case where the oxide film is formed on the first surface in step C is described as an example. However, the present disclosure is not limited to such embodiments. The film selectively formed on the first surface may be any film that is able to be formed on the first surface after step B, and may be, for example, a nitride film or a simple film of Si or a metal element. In this embodiment, it is possible to obtain the same effects as those of the above-described embodiments.

For example, in the above-described embodiments, the case where the first termination formed on the first surface and the second termination formed on the second surface are both terminations that impart hydrophobicity to the surfaces on which they are formed is described as an example. However, the present disclosure is not limited to such embodiments. For example, at least one selected from the group of the first termination and the second termination may be a termination that imparts hydrophobicity to the surface on which the termination is formed. In this embodiment, it is possible to obtain the same effects as those of the above-described embodiments.

For example, in the above-described embodiments, the case where the film-forming agent is supplied to the wafer 200 after performing step B is described as an example. However, the present disclosure is not limited to such embodiments. For example, an etching agent may be supplied to the wafer 200 after performing step B. In this embodiment, it is possible to obtain the same effects as those of the above-described embodiments. That is, it is possible to perform a selective etching process on the first surface.

It is desirable that the recipe used for each processing is prepared separately according to process contents and are recorded and stored in the memory 121c via an electric communication line or an external memory 123. When starting each processing, it is desirable that the CPU 121a properly selects an appropriate recipe according to the process contents from a plurality of recipes recorded and stored in the memory 121c. This allows a single substrate processing apparatus 100 to form films of various film types, composition ratios, film qualities, and film thicknesses with good reproducibility. This also reduces burden on an operator and enables each process to be started quickly while avoiding operational errors.

The above-mentioned recipe is not limited to being newly created, but may be prepared, for example, by modifying an existing recipe that is already installed in the substrate processing apparatus 100. When modifying a recipe, the modified recipe may be installed in the substrate processing apparatus 100 via an electric communication line or a recording medium on which the recipe is recorded. In addition, an existing recipe that is already installed in the substrate processing apparatus 100 may be directly modified by operating the input/output device 122 included in the existing substrate processing apparatus 100.

In the above-described embodiments, there is described the example in which a film is formed using a batch-type substrate processing apparatus 100 that processes multiple substrates at a time. The present disclosure is not limited to the above-described embodiments, and may be suitably applied to, for example, a case where a film is formed using a single-substrate-type substrate processing apparatus 100 that processes one or several substrates at a time. In addition, in the above-described embodiments, there is described the example in which a film is formed using the substrate processing apparatus 100 with a hot-wall-type process furnace. The present disclosure is not limited to the above-described embodiments, and may be suitably applied to a case where a film is formed using a substrate processing apparatus 100 with a cold-wall-type process furnace.

Even when these substrate processing apparatuses 100 are used, each process may be performed under the same processing procedures and processing conditions as those of the above-described embodiments and modifications, and it is possible to obtain same effects as those of the above-described embodiments and modifications.

The above-described embodiments and modifications may be used in combination as appropriate. The processing procedure and processing conditions at this time may be, for example, the same as the processing procedures and processing conditions of the above-described embodiments and modifications.

According to the present disclosure in some embodiments, it is possible to selectively process a desired surface among inner surfaces of a recess formed on a substrate.

While certain embodiments are described, these embodiments are presented by way of example, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200), comprising:
(a) preparing the substrate (200) including a first surface, which includes a first termination and constitutes at least a portion of an inner surface of a recess, and a second surface, which includes a second termination different from the first termination; and
(b) removing the first termination selectively with respect to the second termination by exposing the substrate (200) to a processing solution containing a liquid that reacts with the first termination and an additive that reduces surface tension of the liquid.

2. The method of Claim 1, further comprising:
(c) forming a film on the first surface by supplying a film-forming agent to the substrate (200) after (b) is performed.

3. The method of Claim 2, wherein the second termination inhibits adsorption of the film-forming agent to the second surface.

4. The method of Claim 2 or 3, wherein the first termination inhibits adsorption of the film-forming agent to the first surface.

5. The method of any one of Claims 1 to 4, wherein the liquid is a liquid of a compound containing an OH termination in a molecule of the compound.

6. The method of any one of Claims 1 to 5, wherein the first termination is a H termination or an alkoxy group termination.

7. The method of any one of Claims 1 to 6, wherein the second termination is an alkyl group termination.

8. The method of any one of Claims 1 to 7, wherein the second surface on which the second termination is formed is more hydrophobic than the first surface on which the first termination is formed.

9. The method of any one of Claims 1 to 8, wherein the liquid that reacts with the first termination is a liquid containing H₂O or H₂O₂.

10. The method of any one of Claims 1 to 9, wherein the additive is a compound including a structural formula R-COH where R is at least one selected from the group of C, H, O, N and F.

11. The method of any one of Claims 1 to 10, wherein (a) includes:
(a-1) forming the first termination on the first surface by supplying a first modifying agent to the substrate (200); and
(a-2) forming the second termination on the second surface by supplying a second modifying agent to the substrate (200).

12. The method of Claim 11, wherein (a) further includes:
(a-3) after (a-1) and before (a-2), forming a third termination on the second surface selectively with respect to the first surface,
wherein in (a-2), the third termination is reacted with the second modifying agent to form the second termination on the second surface.

13. A method of manufacturing a semiconductor device, comprising the method of Claim 1.

14. A program that causes, by a computer, a substrate processing apparatus to perform:
(a) preparing a substrate (200) including a first surface, which includes a first termination and constitutes at least a portion of an inner surface of a recess, and a second surface, which includes a second termination different from the first termination; and
(b) removing the first termination selectively with respect to the second termination by exposing the substrate (200) to a processing solution containing a liquid that reacts with the first termination and an additive that reduces surface tension of the liquid.

15. A substrate processing apparatus (100), comprising:
a first modifying agent supply system configured to supply a first modifying agent to a substrate (200);
a second modifying agent supply system configured to supply a second modifying agent to the substrate (200),
a processing solution supply system configured to supply a processing solution to the substrate (200); and
a controller (121) configured to be capable of controlling the first modifying agent supply system, the second modifying agent supply system and the processing solution supply system so as to perform a process including:
forming a first termination on a first surface, which constitutes at least a portion of an inner surface of a recess included in the substrate (200), by supplying the first modifying agent to the substrate (200),
forming a second termination on a second surface included in the substrate (200) by supplying the second modifying agent to the substrate (200), and
removing the first termination selectively with respect to the second termination by exposing the substrate (200) to the processing solution containing a liquid that reacts with the first termination and an additive that reduces surface tension of the liquid.
